# EUROPEAN PATENT SPECIFICATION

(11) **EP 3 329 502 B1**
(45) Date of publication and mention of the grant of the patent: **18.03.2020**
(21) Application number: 16750665.8
(22) Date of filing: 27.07.2016
(51) Int. Cl.: H01F 27/28, H01F 27/32, H01F 38/30, G01R 15/18

(54) **CURRENT TRANSFORMER HAVING MULTI-TURN CONDUCTIVE ROD**
STROMWANDLER MIT LEITFÄHIGEM STAB MIT MEHRFACHDREHUNG
TRANSFORMATEUR DE COURANT À TIGE CONDUCTRICE MULTI-TOUR

(30) Priority: 31.07.2015 CN 201510465147
(43) Date of publication of application: 06.06.2018
(73) Proprietor: Siemens Aktiengesellschaft, 80333 München (DE)
(72) Inventor: HAN, Xiao Xiao, Shanghai 201102 (CN); SHI, Zhi Qiang, Shanghai 200124 (CN)
(74) Representative: Patentanwaltskanzlei WILHELM & BECK
(86) International application number: PCT/EP2016/067879
(87) International publication number: WO 2017/021248

(56) References cited:
- GB-A- 774 638
- GB-A- 2 473 014
- US-A- 3 725 741

## Description

### Related application

This application claims priority of Chinese patent application 2015104651472, filed July 31, 2015.

### Technical field

The present invention relates to a current transformer, in particular to a current transformer having a multi-turn conductive rod.

### Background art

A current transformer, such as a gas-insulated current transformer or oil-immersed current transformer, has a device body, an iron core fixed to the device body, and a conductive rod passing through the iron core. The conductive rod used in a conventional current transformer usually has one or two turns, and such a conductive rod is capable of meeting requirements in scenarios requiring a high current ratio. In the case of a scenario requiring a low current ratio, the number of turns on the conductive rod must be increased, to increase precision. However, there is a problem in the prior art, namely the question of how to ensure the level of insulation between turns, and have sufficient mechanical strength, and allow the current transformer to still have a compact volume, while increasing precision.

GB774638A discloses the features of the first part of claim 1.

US3725741A discloses a further a current transformer. GB2473014A discloses a discloses a current transformer having resistive shunts in a fan shaped form.

### Content of the invention

The object to be solved by the present invention is to have a compact volume transformer in case of a scenario requiring a low current ratio.

This object is met by claim 1. Preferred embodiments are disclosed in the dependent claims.

The present invention provides a current transformer having a multi-turn conductive rod, which can ensure the level of insulation between turns, and have sufficient mechanical strength, and allow the current transformer to still have a compact volume, while increasing precision. The current transformer comprises a device body, an iron core and a multi-turn conductive rod, wherein the iron core is fixed to the device body. The multi-turn conductive rod passes through the iron core and comprises a tubular conductor and multiple fan-shaped conductors, wherein an insulating material is packed between the tubular conductor and the fan-shaped conductors, fixing and insulating from one another the tubular conductor and the fan-shaped conductors.

According to one aspect of the present invention, the fan-shaped conductors have circle centers which coincide with an axis of the tubular conductor, and are uniformly distributed around the axis of the tubular conductor. The coincidence of the circle centers of the fan-shaped conductors with the axis of the tubular conductor and the uniform distribution of the fan-shaped conductors are conducive to obtaining a more uniform electric field.

According to another aspect of the present invention, the multi-turn conductive rod also comprises a central conductor. An axis of the central conductor coincides with the axis of the tubular conductor, and is surrounded by the fan-shaped conductors. The coincidence of a circle center of the central conductor with the axis of the tubular conductor is conducive to obtaining a more uniform electric field.

According to another aspect of the present invention, the fan-shaped conductors turn through a certain angle around the axis of the tubular conductor. The turning of the fan-shaped conductors facilitates series connections between the conductors.

According to another aspect of the present invention, the tubular conductor, the fan-shaped conductors and the central conductor are electrically connected to each other in series.

According to another aspect of the present invention, the multi-turn conductive rod has four identical said fan-shaped conductors which turn through an angle of 90 degrees in the same direction around the axis of the tubular conductor. A six-turn conductive rod markedly increases the number of turns of a primary conductor, and can meet the requirements for high-precision measurement of small currents.

According to another aspect of the present invention, the four fan-shaped conductors and the central conductor are electrically connected to each other in series by means of four busbars. The series connection of the four fan-shaped conductors by means of four busbars is structurally simple.

According to another aspect of the present invention, the four busbars are insulated from each other by means of an insulating strip.

According to another aspect of the present invention, the four busbars are fixed to the device body by means of multiple press blocks.

According to another aspect of the present invention, the insulating material is epoxy resin.

Preferred embodiments are explained below in a clear and easy to understand way with reference to the accompanying drawings, to further illustrate the abovementioned characteristics, technical features, advantages and modes of implementation thereof.

### Description of the accompanying drawings

The accompanying drawings below merely illustrate and explain the present invention schematically, without limiting the scope thereof.
Fig. 1 is a schematic diagram of an embodiment of the current transformer of the present invention;
Fig. 2 is a partial schematic diagram of another side of the current transformer of the present invention, viewed from a direction opposite to that in Fig. 1;
Fig. 3 is a schematic perspective drawing of an embodiment of the multi-turn conductive rod in the present invention;
Fig. 4 is a schematic diagram of the series connection method of the multi-turn conductive rod in the present invention.

**Key:**

| | |
|---|---|
| 1 | multi-turn conductive rod |
| 11 | tubular conductor |
| 12 | first fan-shaped conductor |
| 13 | second fan-shaped conductor |
| 14 | third fan-shaped conductor |
| 15 | fourth fan-shaped conductor |
| 16 | central conductor |
| 2 | insulating material |
| 3 | device body |
| 41 | first busbar |
| 42 | second busbar |
| 43 | third busbar |
| 44 | fourth busbar |
| 51, 52, 53, 54 | press block |
| 6 | insulating strip |
| 7 | insulating sheath |
| 8 | base |

### Particular embodiments

To furnish a clearer understanding of the technical features, objects and effects of the present invention, particular embodiments thereof are now explained with reference to the accompanying drawings, in which identical labels indicate components with the same structure or components with similar structures but the same function.

In this text, "schematic" means "serving as a real instance, an example or an illustration". No drawing or embodiment described as "schematic" herein should be interpreted as a more preferred or more advantageous technical solution.

To make the drawings appear uncluttered, only those parts relevant to the present invention are shown schematically in the drawings; they do not represent the actual structure thereof as a product. Furthermore, to make the drawings appear uncluttered for ease of understanding, in the case of components having the same structure or function in certain drawings, only one of these is drawn schematically, or only one is marked.

In this text, "a" does not only mean "just this one", but may also mean the case of "more than one". In this text, "top", "bottom", "front", "rear", "left" and "right" etc. are merely used to indicate a positional relationship between relevant parts, not to define their absolute positions.

In this text, "first" and "second" etc. are merely used to differentiate between parts, not to indicate their order and degrees of importance, etc.

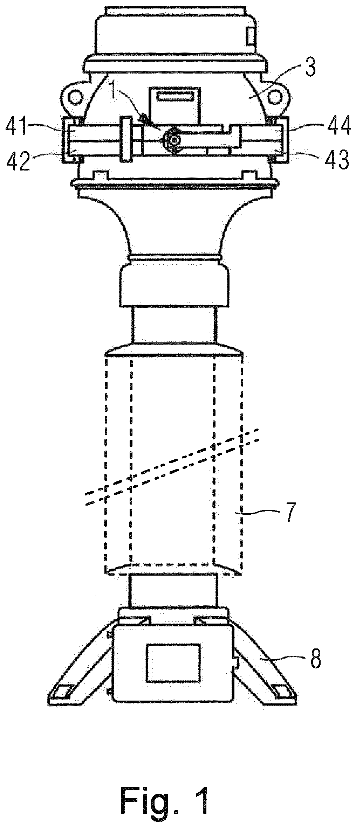

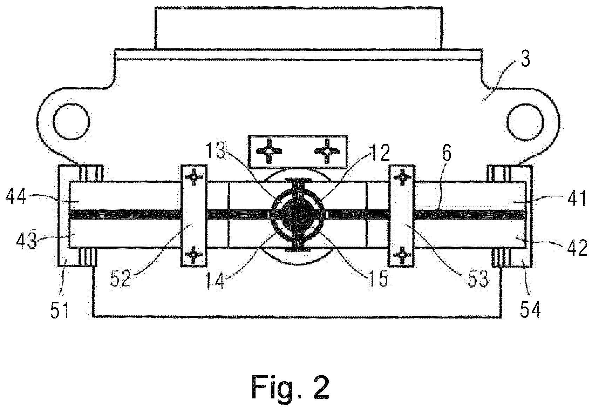

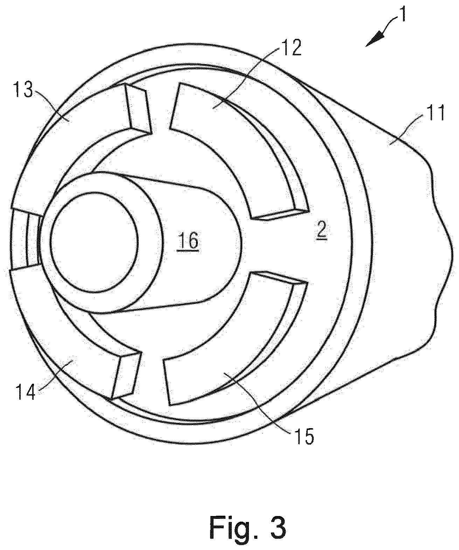

Fig. 1 shows a gas-insulated current transformer according to an embodiment of the present invention, comprising in sequence from top to bottom a device body 3, an insulating sheath 7 and a base 8. A multi-turn conductive rod 1 is located in a middle part of the device body 3, and connected via four busbars 41, 42, 43 and 44. Those skilled in the art will understand that although the figure shows a gas-insulated current transformer, a multi-turn conductive rod may also be used in current transformers of other types, e.g. an oil immersed current transformer. Fig. 2 is a partial schematic diagram of another side of the current transformer in Fig. 1, viewed from a direction opposite to that in Fig. 1. As Figs. 1 and 2 show, the current transformer of the present invention comprises a device body 3, an iron core (not shown) and a multi-turn conductive rod 1, wherein the iron core is fixed to the device body 3. The multi-turn conductive rod 1 passes through the iron core and as shown in Fig. 3 comprises a tubular conductor 11 and four fan-shaped conductors, namely a first fan-shaped conductor 12, a second fan-shaped conductor 13, a third fan-shaped conductor 14 and a fourth fan-shaped conductor 15. Those skilled in the art will understand that there may be at least two fan-shaped conductors, or more than four fan-shaped conductors, in other embodiments of the present invention which are not shown. The first fan-shaped conductor 12, second fan-shaped conductor 13, third fan-shaped conductor 14 and fourth fan-shaped conductor 15 have circle centers which coincide with an axis of the tubular conductor 11, and are uniformly distributed around the axis of the tubular conductor 11. The coincidence of the circle centers of the fan-shaped conductors with the axis of the tubular conductor and the uniform distribution of the fan-shaped conductors are conducive to obtaining a more uniform electric field. Insulating material 2 (e.g. epoxy resin) is packed between the tubular conductor 11 and the first fan-shaped conductor 12, second fan-shaped conductor 13, third fan-shaped conductor 14 and fourth fan-shaped conductor 15, fixing and insulating from one another the tubular conductor 11 and the first fan-shaped conductor 12, second fan-shaped conductor 13, third fan-shaped conductor 14 and fourth fan-shaped conductor 15. The conductor structure of the conductive rod of the current transformer of the present invention greatly increases the space utilization rate without changing the electric field distribution. For a fixed cross-sectional area, a current transformer employing such a conductive rod has a smaller volume, a more compact structure, and lower costs.

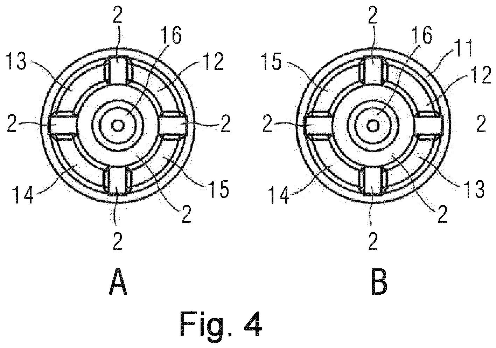

The multi-turn conductive rod 1 in Fig. 3 also comprises a central conductor 16; an axis of the central conductor 16 coincides with the axis of the tubular conductor 11, and is surrounded by the fan-shaped conductors. The coincidence of a circle center of the central conductor with the axis of the tubular conductor is conducive to obtaining a more uniform electric field. The central conductor 16 is a metal bar. A six-turn conductive rod markedly increases the number of turns of a primary conductor, and can meet the requirements for high-precision measurement of small currents, such as a primary current of 30A. The tubular conductor 11, first fan-shaped conductor 12, second fan-shaped conductor 13, third fan-shaped conductor 14, fourth fan-shaped conductor 15 and central conductor 16 are electrically connected to each other in series. In an embodiment which is not shown, the abovementioned conductors may also be electrically connected in parallel. The first fan-shaped conductor 12, second fan-shaped conductor 13, third fan-shaped conductor 14 and fourth fan-shaped conductor 15 of the multi-turn conductive rod 1 are identical. The four fan-shaped conductors, i.e. the first fan-shaped conductor 12, second fan-shaped conductor 13, third fan-shaped conductor 14 and fourth fan-shaped conductor 15 turn through an angle of 90 degrees in the same direction around the axis of the tubular conductor 11, wherein Fig. 4A shows the positions of the fan-shaped conductors corresponding to Fig. 2, and Fig. 4B shows the positions of the fan-shaped conductors corresponding to Fig. 1. Those skilled in the art will understand that although the four fan-shaped conductors shown in the figures turn through an angle of 90 degrees, the conductors may turn through another angle according to the number thereof and requirements so as to facilitate electrical connection of the conductors. For example, in the case of three fan-shaped conductors, each fan-shaped conductor turns through an angle of 120 degrees. The turning of the fan-shaped conductors facilitates series connections between the conductors. The first fan-shaped conductor 12, second fan-shaped conductor 13, third fan-shaped conductor 14, fourth fan-shaped conductor 15 and central conductor 16 are electrically connected to each other in series by means of four busbars. The four busbars are insulated from each other by means of an insulating strip 6 and respectively surround the device body 3, the four busbars being fixed to the device body 3 by means of multiple press blocks 51, 52, 53 and 54. Specifically, the four busbars are a first busbar 41, a second busbar 42, a third busbar 43 and a fourth busbar 44, wherein the first busbar 41 electrically connects the first fan-shaped conductor 12 and the fourth fan-shaped conductor 15, the second busbar 42 electrically connects the fourth fan-shaped conductor 15 and the third fan-shaped conductor 14, the third busbar 43 electrically connects the third fan-shaped conductor 14 and the second fan-shaped conductor 13, and the fourth busbar 44 electrically connects the second fan-shaped conductor 13 and the central conductor 16. In addition, the tubular conductor 11 is also electrically connected to the first fan-shaped conductor 12 by means of the housing of the device body 3, thereby electrically connecting the tubular conductor 11, fan-shaped conductors 12, 13, 14 and 15 and the central conductor 16 to each other in series.

## Claims

1. A current transformer having a multi-turn conductive rod, comprising:
a device body (3);
an iron core, fixed to the device body (3); and
a multi-turn conductive rod (1), which passes through the iron core and comprises a tubular conductor (11) and multiple conductors (12, 13, 14, 15), wherein an insulating material (2) is packed between the tubular conductor (11) and the conductors (12, 13, 14, 15), fixing and insulating from one another the tubular conductor (11) and the conductors (12, 13, 14, 15);
**characterized in that**
the multiple conductors (12, 13, 14, 15) are fan-shaped, wherein the fan-shaped conductors are electrically connected with each other.

2. The current transformer as claimed in claim 1, wherein the fan-shaped conductors (12, 13, 14, 15) have circle centers which coincide with an axis of the tubular conductor (11), and are uniformly distributed around the axis of the tubular conductor (11) .

3. The current transformer as claimed in claim 1 or 2, wherein the multi-turn conductive rod (1) also comprises a central conductor (16), an axis of the central conductor (16) coincides with the axis of the tubular conductor (11), and is surrounded by the fan-shaped conductors (12, 13, 14, 15).

4. The current transformer as claimed in claim 3, wherein the fan-shaped conductors (12, 13, 14, 15) turn through a certain angle around the axis of the tubular conductor (11).

5. The current transformer as claimed in claim 4, wherein the tubular conductor (11), the fan-shaped conductors (12, 13, 14, 15) and the central conductor (16) are electrically connected to each other in series.

6. The current transformer as claimed in claim 5, wherein the multi-turn conductive rod (1) has four identical said fan-shaped conductors (12, 13, 14, 15) which turn through an angle of 90 degrees in the same direction around the axis of the tubular conductor (11).

7. The current transformer as claimed in claim 6, wherein the four fan-shaped conductors (12, 13, 14, 15) and the central conductor (16) are electrically connected to each other in series by means of four busbars (41, 42, 43, 44).

8. The current transformer as claimed in claim 7, wherein the four busbars (41, 42, 43, 44) are insulated from each other by means of an insulating strip (6).

9. The current transformer as claimed in claim 8, wherein the four busbars (41, 42, 43, 44) are fixed to the device body (3) by means of multiple press blocks (51, 52, 53, 54).

10. The current transformer as claimed in any of claims 1 to 9, wherein the insulating material (2) is epoxy resin.

## Patentansprüche

1. Stromwandler mit leitfähigem Stab mit Mehrfachdrehung, umfassend:
einen Vorrichtungskörper (3);
einen Eisenkern, der an dem Vorrichtungskörper (3) fixiert ist;
einen leitfähigen Stab mit Mehrfachdrehung (1), welcher den Eisenkern durchläuft und einen röhrenförmigen Leiter (11) und mehrere Leiter (12, 13, 14, 15) umfasst, wobei zwischen den röhrenförmigen Leiter (11) und die Leiter (12, 13, 14, 15) ein Isoliermaterial (2) gepackt ist, wodurch der röhrenförmige Leiter (11) und die Leiter (12, 13, 14, 15) fixiert und voneinander isoliert werden;
**dadurch gekennzeichnet, dass**
die mehreren Leiter (12, 13, 14, 15) fächerförmig sind,
wobei die fächerförmigen Leiter elektrisch miteinander verbunden sind.

2. Stromwandler nach Anspruch 1, wobei die fächerförmigen Leiter (12, 13, 14, 15) Kreismittelpunkte aufweisen, die mit einer Achse des röhrenförmigen Leiters (11) zusammenfallen, und um die Achse des röhrenförmigen Leiters (11) herum gleichförmig verteilt sind.

3. Stromwandler nach Anspruch 1 oder 2, wobei der leitfähige Stab mit Mehrfachdrehung (1) auch einen Zentralleiter (16) umfasst, eine Achse des Zentralleiters (16) mit der Achse des röhrenförmigen Leiters (11) zusammenfällt und von den fächerförmigen Leitern (12, 13, 14, 15) umgeben ist.

4. Stromwandler nach Anspruch 3, wobei die fächerförmigen Leiter (12, 13, 14, 15) sich über einen bestimmten Winkel um die Achse des röhrenförmigen Leiters (11) herum drehen.

5. Stromwandler nach Anspruch 4, wobei der röhrenförmige Leiter (11), die fächerförmigen Leiter (12, 13, 14, 15) und der Zentralleiter (16) elektrisch in Reihe miteinander verbunden sind.

6. Stromwandler nach Anspruch 5, wobei der leitfähige Stab mit Mehrfachdrehung (1) vier identische derartige fächerförmige Leiter (12, 13, 14, 15) aufweist, die sich über einen Winkel von 90 Grad in derselben Richtung um die Achse des röhrenförmigen Leiters (11) herum drehen.

7. Stromwandler nach Anspruch 6, wobei die vier fächerförmigen Leiter (12, 13, 14, 15) und der Zentralleiter (16) elektrisch in Reihe mithilfe von vier Sammelschienen (41, 42, 43, 44) miteinander verbunden sind.

8. Stromwandler nach Anspruch 7, wobei die vier Sammelschienen (41, 42, 43, 44) mithilfe eines Isolierstreifens (6) voneinander isoliert sind.

9. Stromwandler nach Anspruch 8, wobei die vier Sammelschienen (41, 42, 43, 44) mithilfe mehrerer Pressblöcke (51, 52, 53, 54) an dem Vorrichtungskörper (3) fixiert sind.

10. Stromwandler nach einem der Ansprüche 1 bis 9, wobei das Isoliermaterial (2) Epoxyharz ist.

## Revendications

1. Transformateur de courant ayant une tige conductrice multitour, comprenant :
un corps de dispositif (3) ;
un noyau en fer, fixé au corps de dispositif (3) ; et
une tige conductrice multitour (1), qui passe à travers le noyau en fer et comprend un conducteur tubulaire (11) et de multiples conducteurs (12, 13, 14, 15), un matériau isolant (2) étant tassé entre le conducteur tubulaire (11) et les conducteurs (12, 13, 14, 15), fixant et isolant les uns des autres le conducteur tubulaire (11) et les conducteurs (12, 13, 14, 15) ;
**caractérisé en ce que**
les multiples conducteurs (12, 13, 14, 15) sont en forme d'éventail,
les conducteurs en forme d'éventail étant reliés électriquement les uns aux autres.

2. Transformateur de courant selon la revendication 1, dans lequel les conducteurs en forme d'éventail (12, 13, 14, 15) ont des centres de cercle qui coïncident avec un axe du conducteur tubulaire (11), et sont distribués uniformément autour de l'axe du conducteur tubulaire (11).

3. Transformateur de courant selon la revendication 1 ou 2, dans lequel la tige conductrice multitour (1) comprend également un conducteur central (16), un axe du conducteur central (16) coïncide avec l'axe du conducteur tubulaire (11), et est entouré par les conducteurs en forme d'éventail (12, 13, 14, 15).

4. Transformateur de courant selon la revendication 3, dans lequel les conducteurs en forme d'éventail (12, 13, 14, 15) tournent d'un certain d'angle autour de l'axe du conducteur tubulaire (11).

5. Transformateur de courant selon la revendication 4, dans lequel le conducteur tubulaire (11), les conducteurs en forme d'éventail (12, 13, 14, 15) et le conducteur central (16) sont reliés électriquement les uns aux autres en série.

6. Transformateur de courant selon la revendication 5, dans lequel la tige conductrice multitour (1) a quatre dits conducteurs en forme d'éventail (12, 13, 14, 15) identiques qui tournent d'un angle de 90 degrés dans la même direction autour de l'axe du conducteur tubulaire (11).

7. Transformateur de courant selon la revendication 6, dans lequel les quatre conducteurs en forme d'éventail (12, 13, 14, 15) et le conducteur central (16) sont reliés électriquement les uns aux autres en série au moyen de quatre barres omnibus (41, 42, 43, 44) .

8. Transformateur de courant selon la revendication 7, dans lequel les quatre barres omnibus (41, 42, 43, 44) sont isolées les unes des autres au moyen d'une bande isolante (6).

9. Transformateur de courant selon la revendication 8, dans lequel les quatre barres omnibus (41, 42, 43, 44) sont fixées au corps de dispositif (3) au moyen de multiples blocs de compression (51, 52, 53, 54).

10. Transformateur de courant selon l'une quelconque des revendications 1 à 9, dans lequel le matériau isolant (2) est de la résine époxy.
